# EUROPEAN PATENT APPLICATION

(11) **EP 4 459 014 A1**
(43) Date of publication of application: **06.11.2024**
(21) Application number: 22915483.6
(22) Date of filing: 24.10.2022
(51) Int. Cl.: C30B 29/38, C30B 25/18, H01L 21/02, H01L 21/20

(54) **HIGH-CHARACTERISTIC EPITAXIAL GROWTH SUBSTRATE AND METHOD FOR MANUFACTURING SAME**

(30) Priority: 28.12.2021 JP 2021214704
(71) Applicant: SHIN-ETSU CHEMICAL CO., LTD., Tokyo 1000005 (JP)
(72) Inventor: KUBOTA Yoshihiro, Annaka-shi, Gunma 379-0195 (JP); KAWAI Makoto, Annaka-shi, Gunma 379-0195 (JP)
(74) Representative: Vossius & Partner Patentanwälte Rechtsanwälte mbB
(86) International application number: PCT/JP2022/039540
(87) International publication number: WO 2023/127249

(57) **Abstract**

A substrate for group-III nitride epitaxial growth and a method for producing the same are provided, which are capable of fabricating a superior characteristics group III nitride single crystal at low cost.

The substrate for group-III nitride epitaxial growth according to the present invention comprises: a supporting substrate having a structure in which a core consisting of nitride ceramic is wrapped in an encapsulating layer having a thickness of between 0.05 µm and 1.5 um, inclusive; a planarizing layer provided on an upper surface of the supporting substrate, the planarizing layer having a thickness of between 0.5 µm and 3.0 µm, inclusive; and a seed crystal layer consisting of a single crystal, the seed crystal layer being provided on an upper surface of the planarizing layer and having a thickness more than 0.04 µm and less than 0.10 µm; and if necessary, a stress adjusting layer on the bottom surface of the support substrate.

## Description

### TECHNICAL FIELD

The present invention relates to seed substrates used for epitaxial growth of epitaxial substrates and solid substrates of group III nitrides with few defects and excellent characteristics, such as aluminum nitride (AlN), aluminum gallium nitride (AlₓGa₁₋ₓN (0 < x < 1)), and gallium nitride (GaN), and manufacturing method thereof. More specifically, it relates to seed substrates for epitaxial growth of epitaxial substrates and solid substrates of group III nitrides such as AlN, AₗₓGa₁₋ₓN (0<X<1) and GaN-based materials with extremely low crystal defects, warpage and voids, and high quality and low cost, and manufacturing method thereof.

### BACKGROUND ART

Group III nitride crystal substrates such as AlN-and GaN-based substrates have a wide band gap and excellent high-frequency characteristics with short wavelength luminescence and high breakdown voltage. Therefore, group III nitride substrates are expected to be applied to devices such as light-emitting diodes (LEDs), lasers, Schottky diodes, power devices, and high-frequency devices. For example, with regard to AlN-based crystal substrates, the recent outbreak of coronavirus and other viruses has triggered a growing demand for AlN and/or AlₓGa₁₋ₓN (0.5 < X < 1) single crystal substrates for light emitting diodes, especially in the deep ultraviolet region (UVC; 200-280 nm), for the purpose of bacterial and virus elimination. However, at present, these single crystal substrates of AlN and/or AlₓGa₁₋ₓN (0.5 < X < 1) have many defects, are of low quality and high cost, and do not have the expected characteristics when various devices are made. Hence, the wide spread of these substrates and the expansion of their applications are limited. On the other hand, GaN-based crystal substrates are required to have higher high-frequency characteristics and greater breakdown voltage performance with the start of 5G communications and the shift to EVs in automobiles. As a result, GaN-based crystal substrates with very few crystal defects and low-cost epitaxial substrates and solid substrates are also in demand. However, as with AlN-based substrates, GaN-based substrates also have many crystal defects and are of low quality, but their prices are high. Therefore, the widespread use of GaN-based substrates for the aforementioned devices has been prevented, and further improvement is desired.

For example, as described in Non-Patent Document 1 and Non-Patent Document 2, AlN single crystal substrates are difficult to manufacture by the melt method commonly used for silicon (Si) single crystals, etc., because AlN has no melting point. So they are usually manufactured by the sublimation method (modified Lely method) using silicon carbide (SiC) or AlN as seed crystals at 1700 to 2250°C under N₂ atmosphere. Alternatively, they are made by the hydride vapor phase epitaxy (HVPE) on sapphire substrates or AlN substrates obtained by the sublimation method, as disclosed in Patent Document 1 and Non-Patent Document 3. Since AlN single crystals manufactured by the sublimation method require high temperatures for crystal growth, only small-diameter substrates of 2 to 4 inches in diameter can be obtained at present due to equipment limitations, and they are extremely expensive. The dislocation density of the AlN single crystals obtained by the sublimation method is relatively low, smaller than 10⁵ cm⁻², but on the other hand, the crystals are colored by carbon and metallic impurities derived from charcoal materials such as crucibles and insulation materials, and have the disadvantages of low resistivity and low UV transmission. On the other hand, AlN single crystals made by hydride vapor phase epitaxy (HVPE) on sapphire substrates are relatively inexpensive and have little coloration, but the difference in lattice constants between AlN and sapphire results in high dislocation density and low resistivity of the AlN crystal. AlN crystals obtained by HVPE deposition on sublimation method AlN substrates have relatively low dislocation density, but are opaque to deep UV emission and have low resistivity due to colorant contamination from the underlying substrate AlN. In addition, the expensive sublimation method AlN crystals are used as the base substrate that also serves as seed crystals, which has the disadvantage of being extremely costly.

As for GaN substrates, bulk GaN substrates made by growing GaN crystals in liquid ammonia or Na flux have relatively few defects and are of high quality, but they are extremely expensive because they require high-temperature, high-pressure equipment. In addition, GaN crystal growth in liquid is extremely costly, as the bulk GaN substrate is used as-is as a base substrate that also serves as a seed crystal, similar to the AlN substrate in the sublimation method described above. On the other hand, if heteroepitaxial growth of GaN crystal is performed on sapphire and other substrates using the MOCVD or hydride vapor deposition (HVPE), which grow crystals in the vapor phase, it is possible in principle to achieve higher crystal quality and larger size. In practice, however, the lattice constants and thermal expansion coefficients between the generated GaN crystals and the underlying sapphire substrate differ greatly, resulting in numerous crystal defects and cracks during production, and high-quality crystals cannot be obtained. Note that with regard to the HVPE method, the trihalide vapor phase epitaxy (THVPE) method, which uses GaCl3 as a precursor, is also collectively referred to as the HVPE method in this specification.

As one of the solutions to these problems, Patent Document 2 discloses a so-called QST (product name) substrate having a support substrate with an AlN ceramic core and an encapsulating layer that encapsulates the AlN ceramic core with a SiO₂/P-Si/SiO₂/Si₃N₄ multilayer film, a planarizing layer such as SiO₂ on the top surface of the support substrate, and a seed crystal layer with Si<111> thin film transferred as a seed crystal on the top surface of the planarizing layer.

However, this method causes a difference in thermal expansion coefficient between the AlN ceramic core and all multilayer films that encapsulate the core, or between each multilayer film, such as the encapsulating layer, planarizing layer, and seed crystal layer, due to the difference in materials. Therefore, thermal stress based on the difference in thermal expansion coefficients between the layers can easily occur. Among these, the thermal stress between the planarizing layer and the seed crystal layer distorts the seed crystal during epitaxial deposition and, as a result, induces a numerous number of crystal defects in the epitaxial film. The inventors have also learned that thermal stress between the AlN ceramic core and the encapsulating layer, planarizing layer, or seed crystal layers causes cracks between the ceramic core and each layer, which diffuses impurity contamination in the ceramic core to the seed crystal and adversely affects epitaxial crystal growth. Furthermore, the inventors have found that when a Si<111> substrate is used as a seed crystal layer on the planarizing layer, the Oxidation Induced Stacking Fault (OSF) described in Patent Document 3 has a significant effect and that the defects in the epitaxial film can be reduced by lowering the OSF to 10 defects/cm² or less, and the inventors have filed separate patent applications (Patent Application 2021-038731 (filed on March 10, 2021) and Patent Application 2021-098993 (filed on June 14, 2021). This restriction on the density of OSF allowed in the seed crystal layer limits the choice of Si<111> seed crystals and also increases the cost. Besides, it was also found that thin-film transfer to form the seed crystal layer has the following drawbacks: after ion implantation, the damaged portions caused by ion implantation must be completely removed from the seed crystal layer when the thin-film transfer is done; otherwise, it will cause many voids and defects in the epitaxial crystal; the presence of poly-Si for electrostatic chuck in the encapsulating layer will cause breakdown voltage degradation and high-frequency loss in the epitaxial substrate and devices that use it.

From the above, it is difficult to obtain, for example, AlN and/or AlₓGa₁₋ₓN (0<X<1) substrates for light-emitting diodes used in the ultra-short wavelength deep ultraviolet region (UVC; 200-280 nm), which require especially low crystal defects and excellent characteristics, or GaN crystal substrates suitable for high frequency and high breakdown voltage for 5G communications and EVs, etc. with low crystal defects, superior characteristics and at a low cost, and new solutions have been desired.

### PRIOR ART DOCUMENTS

### PATENT DOCUMENTS

Patent Document 1: JP6042545B
Patent Document 2: JP6626607B
Patent Document 3: JP2936916B

### NON-PATENT DOCUMENTS

Non-Patent Document 1: Japanese Journal of Applied Physics; Vol.46,No.17,2007,pp.L389-L391
Non-Patent Document 2: SEI Technical Review; No. 177, pp. 88-91
Non-Patent Document 3: Fujikura Technical Review; No. 119, 2010, Vol. 2, pp. 33-38
Non-Patent Document 4: LEDs Magazine Japan; December 2016, pp. 30-31

### SUMMARY OF THE INVENTION

### PROBLEMS TO BE SOLVED BY THE INVENTION

The inventors have, therefore, studied various ways to solve the above problems and, as a result, have arrived at the present invention.

### MEANS FOR SOLVING THE PROBLEMS

There are three key components of the invention. The first of these is to minimize the difference in thermal expansion coefficient between each multilayer film that encapsulates the core described above, or between the encapsulating layer, the planarizing layer, and the seed crystal layer, and to optimize the composition and thickness of the encapsulating layer, the planarizing layer, and the seed crystal layer in a balanced manner. The second is to separately add a stress adjusting layer, if necessary, to the bottom surface of the support substrate, which serves both for stress adjustment and electrostatic chucking, and to achieve a configuration that balances and minimizes the thermal stresses. The third is to make the thickness of the seed crystal layer extremely thin, in the range of 0.04 um or more and less than 0.10 µm, in order to achieve low stress between the seed crystal layer and the planarizing layer as well as to completely remove the damaged portions of the seed crystal layer that were peeled off and the thin film transferred by ion implantation.

As described in more detail below, the substrate for group III nitride epitaxial growth according to the present invention, includes: a supporting substrate having a structure in which a core consisting of nitride ceramic is wrapped in an encapsulating layer having a thickness of between 0.05 um and 1.5 µm, inclusive; a planarizing layer provided on an upper surface of the supporting substrate, the planarizing layer having a thickness of between 0.5 µm and 3.0 µm, inclusive; and a seed crystal layer consisting of a single crystal, the seed crystal layer being provided on an upper surface of the planarizing layer and having a thickness more than 0.04 um and less than 0.1 um.

In the present invention, a stress adjusting layer may be further provided on the bottom surface of the support substrate.

In the present invention, the core may be aluminum nitride ceramic.

In the present invention, the encapsulating layer may include at least silicon nitride.

In the present invention, the planarizing layer may contain any one of silicon oxide, silicon oxynitride, and aluminum arsenide.

In the present invention, the seed crystal layer may be Si <111>, SiC, sapphire, aluminum nitride, aluminum gallium nitride, or gallium nitride.

In the present invention, the stress adjusting layer may include, at least, silicon.

In addition, a method for manufacturing a substrate for group III nitride epitaxial growth according to the present invention includes the steps of: preparing a core consisting of nitride ceramic; obtaining a supporting substrate by depositing an encapsulating layer so as to wrap the core, the encapsulating layer having a thickness of between 0.05 um and 1.5 µm, inclusive; depositing a planarizing layer on an upper surface of the supporting substrate, the planarizing layer having a thickness of between 0.5 µm and 3.0 um, inclusive; and providing a seed crystal layer consisting of a single crystal with a thickness of more than 0.04 um and less than 0.10 µm on an upper surface of the planarizing layer.

In the present invention, a step of depositing a stress adjusting layer on the bottom surface of the support substrate may be further provided.

In the present invention, the encapsulating layer may be deposited by using an LPCVD method.

In the present invention, the planarizing layer may be deposited by using any one of a plasma CVD method, an LPCVD method, and a low-pressure MOCVD method.

In the present invention, the step of providing a seed crystal layer may include the steps of: preparing a single crystal substrate of a group III nitride, one surface of the single crystal substrate being an ion implantation surface; forming a peeling position in the single crystal substrate by performing ion implantation from the ion implantation surface; obtaining a bonded substrate by bonding the ion implantation surface and the planarizing layer; and separating the bonded substrate into the seed crystal layer and a remaining section of the single crystal substrate at the peeling position.

In the present invention, in the step of preparing the single crystal substrate, aluminium nitride, aluminium gallium nitride or gallium nitride epitaxially grown on a sapphire substrate by MOCVD or HVPE may be fabricated as the single crystal substrate.

In the present invention, in the step of preparing the single crystal substrate, the single crystal substrate may be obtained by bonding small-diameter single crystals made by epitaxial growth of aluminium nitride or aluminium gallium nitride by MOCVD or HVPE using a small-diameter aluminium nitride single crystal fabricated by the sublimation method or an aluminium nitride substrate fabricated by the sublimation method as a base.

In the present invention, in the step of preparing the single crystal substrate, the single crystal substrate may be obtained by bonding small-diameter single crystals made by epitaxial growth of aluminium nitride or aluminium gallium nitride by MOCVD or HVPE using a small-diameter gallium nitride single crystal obtained by growing gallium nitride crystal in liquid ammonia or Na flux as a base.

In the present invention, in the step of forming the peeling position, the peeling position may be formed within the epitaxial layer grown by epitaxial growth.

In the present invention, the remaining section of the single crystal substrate may be reused as a base substrate for epitaxial growth.

In the present invention, the remaining section of the single crystal substrate may be reused as a single crystal substrate in the production of a further different group III nitride composite substrate.

In the present invention, the core may be aluminum nitride ceramic.

In the present invention, the encapsulating layer may contain silicon nitride.

In the present invention, the planarizing layer may contain any one of silicon oxide, silicon oxynitride, and aluminum arsenide.

In the present invention, the seed crystal layer may be Si<111>, SiC, sapphire, aluminum nitride, or aluminum gallium nitride.

In the present invention, the stress adjusting layer may include, at least, silicon.

### EFFECT OF THE INVENTION

The present invention enables to provide high-quality and low-cost seed substrates for epitaxial growth of epitaxial substrates and solid substrates of group III nitrides such as AlN and/or AlxGa1-xN (0<X<1) substrates for light emitting diodes used in the deep ultraviolet region (UVC; 200-280nm), or GaN crystal substrates suitable for high frequency and high breakdown voltage applications associated with 5G communication and shift to EVs in automobiles, with few defects and at low cost. In the previous patent application (JP 2021-098993), when the seed crystal is Si<111> crystal, the number of oxidation-induced stacking faults (OSF) is limited to 10 or less to obtain good epi, but in this patent application, the same results as in the previous application can be obtained even if the number of OSF is several tens, which greatly expands the choices for seed crystals and contributes to cost reduction.

### BRIEF DESCRIPTION OF THE DRAWINGS

FIG. 1 is a diagram showing the cross-sectional structure of a seed substrate 1.
FIG. 2 is a diagram showing the procedure for manufacturing the seed substrate 1.

### EMBODIMENTS OF THE INVENTION

The embodiments of the present invention will be described in detail hereinafter, but the present invention is not limited thereto.

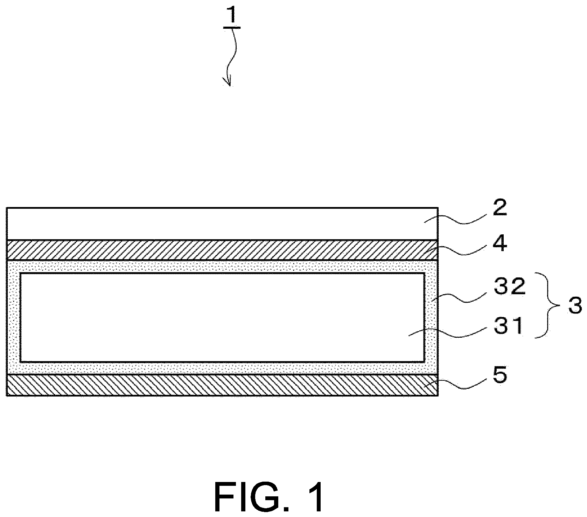

FIG. 1 shows a cross-sectional structure of a seed substrate for epitaxial growth of group III nitrides (hereinafter simply referred to as "seed substrate") 1. The seed substrate 1 shown in FIG. 1 has a structure in which a planarizing layer 4 and a seed crystal layer 2, such as Si<111>, are stacked on a support substrate 3. In addition, if necessary, the stress adjusting layer 5 is provided on the surface (bottom surface) of the support substrate 3 opposite the surface on which the planarizing layer 4 is stacked.

The support substrate 3 has a core 31 serving as the core material of the support substrate 3 and an encapsulating layer 32 covering the core 31.

The core 31 is formed by group III nitride polycrystalline ceramic. Specifically, AlN, Si₃N₄, GaN, or a mixture of these materials can be used. Polycrystalline AlN ceramic is suitable because it has the lattice constant and thermal expansion coefficient close to those of the target group III nitride crystal, has high thermal conductivity, and is inexpensive. In terms of device processing, wafers with a mirror finish of 200 to 1000 µm thickness should be selected, which can be handled in semiconductor production lines. There are various manufacturing methods of AlN ceramics, but because of their productivity, the so-called sheet forming/atmospheric pressure sintering method is commonly used. In the sheet forming/atmospheric pressure sintering method, AlN powder, sintering agent, organic binders, and solvents are mixed to create wafer-like green sheets, which are then degreased, sintered in an N₂ atmosphere, and polished to obtain AlN ceramic wafers. The sintering agent may be selected from Y₂O₃, Al₂O₃, CaO, and the like, but Y₂O₃ is usually the most suitable because it exhibits the highest thermal conductivity in the substrate after sintering.

The encapsulating layer 32 may include at least silicon nitride. In encapsulating layer 32, if the thickness of each layer becomes too thick, the stress between the layers increases due to the difference in thermal expansion coefficient, causing delamination between the layers. Therefore, even if films of various compositions are selected and combined, it is not desirable for the thickness of the encapsulating layer 32 to be more than 1.5 um. On the other hand, in terms of the function of sealing impurities, a thickness of 0.05 µm or less is insufficient to prevent the diffusion of impurities. From the above, the thickness of the encapsulating layer 32 is preferably in the range of 0.05 to 1.5 um. The deposition method for the encapsulating layer can be selected from conventional deposition methods such as MOCVD, atmospheric pressure CVD, LPCVD, sputtering, etc. The LPCVD is preferred because of the film quality, the film coverage, and the ability to prevent impurity diffusion.

A planarizing layer 4 of 0.5 to 3 µm is stacked on the encapsulating layer 32, at least on the top surface of the support substrate 3. The planarizing layer 4 is selected from ordinary ceramic film materials such as SiO₂, Al₂O₃, Si₃N₄, SiC, or silicon oxynitride (SiₓO_{y}N_{z}), etc., or Si, GaAs, AlAs, etc., which are often used as sacrificial layers for etching, etc. It is preferable to select SiO₂ and/or silicon oxynitride (SiₓO_{y}N_{z}) or AlAs, which are easy to grind or polish during planarization and easy to separate when obtaining solid substrates.

The planarizing layer 4 is normally stacked only on one side of the encapsulating layer 32 from a cost standpoint, but if the warpage is large, it can be deposited to cover the entire encapsulating layer 32. The thickness of the planarizing layer 4 must be thick enough to fill voids and irregularities in core 31 and encapsulating layer 32, etc., and smooth enough to transfer seed crystals. However, a planarizing layer 4 that is too thick is undesirable because it can cause warping and cracking of the seed substrate 1. Therefore, it is suitable to provide a planarizing layer with a thickness of 0.5 to 3 µm on at least the top surface of the support substrate. This is because if the thickness is less than 0.5 µm, it is almost impossible to fill the voids and unevenness in the AlN ceramic core 31 and encapsulating layer 32, and if the thickness is 3 µm or more, warping by the planarizing layer 4 is likely to occur.

Plasma CVD, LPCVD, or low-pressure MOCVD are suitable for the deposition of the planarizing layer 4 in terms of its required film quality and deposition efficiency. The stacked planarizing layer is heat treated for vitrification or CMP polished for planarization, depending on the film conditions, to prepare for thin-film transfer of the seed crystal layer 2 described below.

The seed crystal layer 2 is provided by thin-film transfer of the seed crystal on the surface of the planarizing layer 4. The seed crystal used for thin film transfer is selected to be a substrate with a crystal structure similar to group III nitrides such as AlN, AlₓGa₁₋ₓN (0<X<1), GaN, etc., which are the subject of the present invention. Therefore, Si<111>, SiC, SCAM, AlN, AlGaN, sapphire, GaN, etc. are suitable. Among these, Si<111> is the most suitable because of its ease of making larger diameters, availability of commercial products, and low cost.

It has already been mentioned that the present inventors have revealed that, as an improvement of the conventional technology, if 0.1 to 1.5 µm of the surface layer of Si<111> crystal with oxidation induced stacking fault (OSF) of less than 10 defects/cm² is used as the seed crystal for epitaxial film, the epitaxial film deposited on the seed crystal has extremely excellent characteristics, and have recently filed a patent application for this improvement. However, this improvement pointed out the importance of the characteristics of the Si<111> substrate of the seed crystal (especially the density of OSF), but on the other hand, it also narrowed down the choices when selecting seed crystals, which was a cause of cost increase. As a result of our intensive study for further improvement, it was found that in thin-film transfer for seed crystal layer formation, when thin-film transfer is performed after ion implantation, damaged portions due to ion implantation (portions of crystal partially damaged by ion implantation, causing amorphous phase, polycrystalline phase, or crystal disorder) remain significantly and cannot be removed by simple polishing or etching, causing many voids and defects in the epitaxial crystal because it is incomplete as the seed crystal layer.

In addition, as mentioned above, the thermal stress is generated between each multi-layered film, such as the AlN ceramic core, encapsulating layer, planarizing layer, and seed crystal layer, due to the difference in thermal expansion coefficient caused by the difference in materials. Among these, the thermal stress between the planarizing layer. and the seed crystal layer distorts or warps the seed crystal during epitaxial deposition and, as a result, induces a number of crystal defects in the epitaxial film. It was also found that thermal stress between the AlN ceramic core and the encapsulating layer, planarizing layer, or seed crystal layers causes cracks or delamination between the ceramic core and each layer, contaminates the seed crystal with impurities in the ceramic core, and adversely affects epitaxial crystal growth.

After various investigations based on these new findings to completely remove the damaged portions of the seed crystal layer 2 that had been ion-implantation peeled and thin film transferred, as well as to reduce the stress between the seed crystal layer and the planarizing layer, the damaged portions of the seed crystal layer 2 due to ion implantation were completely removed by polishing, etching, plasma assisted chemical etching (PACE), sacrificial oxidation, or a combination of these methods, and the thickness of the seed crystal layer 2 was made extremely thin to minimize thermal stress, resulting in extremely good epitaxial film characteristics.

That is, the present invention does not use 0.1 to 1.5 µm, the thickness of the seed crystal at the time of thin-film transfer, which is conventionally preferred for the seed crystal, as it is or with incomplete removal of damage, but instead removes the damaged portions of the seed crystal in a lump or completely and makes the thickness of the seed crystal layer 2 on the planarizing layer 4 extremely thin to follow the thermal stress of the planarizing layer 4. The film thickness was found to be suitable in the range of more than 0.04 µm and less than 0.10 um. By extremely thinning the film to this thickness using the above method, the damaged portions caused by ion implantation are completely removed, and the seed crystal layer 2 can follow the thermal stress of the planarizing layer 4, resulting in no strain in the seed crystal layer 2 and superior epitaxial film characteristics. In addition, when Si<111> is used as the seed crystal, superior epitaxial film can be produced even if the OSF is not less than 10 defects/cm² as described above, which expands the selection of Si seed crystals and contributes to the cost reduction.

However, the film thickness of less than 0.04 µm is so extremely thin that even with the above methods, such as polishing, etching, PACE, sacrificial oxidation, or a combination of these methods, the seed crystal layer 2 may be damaged, or depending on the in-plane distribution, there may be areas where the seed crystal layer 2 is lost, and thus the layer may no longer function as the seed. A film thickness of 0.10 um or thicker is undesirable because damaged portions caused by ion implantation may remain, or the seed crystal layer 2 may not be able to follow the thermal stress of the planarizing layer 4, resulting in cracks or distortion.

Based on the above, in the present invention, the transferred thickness of the seed crystal layer 2 (thickness immediately after the transfer, before the damaged portion is removed) is preferable to be 0.20 to 0.50 µm. Even more preferably, it should be 0.20 to 0.30 µm. As mentioned above, (1) the suitable thickness of the final seed crystal layer is between 0.04 and 0.10 um, (2) the damage layer by ion implantation is close to 0.1 µm, and (3) variations in damage removal methods such as ion implantation, polishing, etching, PACE, or sacrificial oxidation should also be considered. Therefore, a transfer thickness of 0.20 to 0.50 um is desirable, and 0.20 to 0.30 µm is more desirable.

When the epitaxial substrates and solid substrates obtained by epitaxial deposition on the seed substrates 1 are used for high-frequency devices, especially for 5G and beyond, it is preferable to select Si<111> seed crystals with an electrical resistivity (room temperature) of 1 kQ-cm or higher. This is because if the electrical resistivity (at room temperature) of the Si<111> seed crystal is less than 1 kQ-cm, its resistance causes high-frequency loss, which increases power consumption and generates heat, degrading device characteristics.

The Si<111> seed crystal is ion-implanted only with hydrogen and/or helium (He) ion species that have little effect on the electrical resistance of the single crystal substrate to achieve the desired film thickness, and then the ion-implanted surface of the Si<111> seed crystal is bonded to the top surface of the planarizing layer 4, and the thin film is peeled off and transferred to the planarizing layer 4 using physical means such as nails at 450°C or lower. The damaged portions of the ion implantation in the seed crystal layer 2 are then completely removed by polishing, etching, plasma-assisted chemical etching (PACE), sacrificial oxidation, or a combination of these methods, and the thickness of the seed crystal layer 2 is made extremely thin in the range more than 0.04 um and less than 0.10 um to minimize thermal stress. Unlike heavy elements such as boron (B), light elements such as hydrogen and He are suitable for ion implantation into seed crystals because ion implantation causes little damage to the seed crystal and does not lower its electrical resistance. In addition, peeling and transferring at low temperatures below 450°C prevents thermal damage to the Si<111> seed crystals, which is unavoidable in the usual smart-cut method of thermal peeling and transferring at high temperatures above 700°C.

To be more specific, after ion implanting hydrogen and/or He into the seed crystal substrate to a depth of 0.20 to 0.5 µm, more preferably 0.20 to 0.3 µm, the top surface of the planarizing layer 4 and the ion-implanted surface of the seed crystal are bonded. Then, the seed crystal may be peeled off by gas pressure, a nail, or other physical methods at temperatures below 450°C. By setting the processing temperature below 450°C, thermal damage due to impurity diffusion and thermal stress that can easily occur in the seed crystals of the transferred thin film due to processing at high temperatures above 450°C can be suppressed.

The portions damaged by the ion implantation on the surface layer of the seed crystal thin film are then completely removed by CMP polishing, etching, plasma-assisted chemical etching (PACE), sacrificial oxidation, or a combination of these methods, and the thickness of the seed crystal layer is made extremely thin in the range more than 0.04 µm and less than 0.10 um, and thermal stress is minimized, thereby the seed crystal layer 2 may be obtained. For ion implantation, it is recommended that SiO₂, etc., be deposited on the ion implantation surface of the seed crystal layer 2 before ion implantation to achieve higher uniformity.

In the present invention, a stress adjusting layer 5 may be further added to the bottom surface of the support substrate 3, if necessary. This stress adjusting layer 5 corrects the warpage of the seed substrate 1 caused mainly by forming the planarizing layer 4. For the stress adjusting layer 5, film material and thickness with a thermal expansion coefficient that enables correction of warpage of the seed substrate 1 are selected. Although not limited to a specific film material, one that is widely used in the semiconductor industry and can be easily and inexpensively deposited is usually selected. For example, silicon or silicon compounds containing at least silicon are suitable, and it is suitable to deposit amorphous Si or polycrystalline Si (p-Si) as the stress adjusting layer 5, which can also serve also for the electrostatic chuck. Polycrystalline Si is particularly preferred for its chemical stability. SiOz and/or silicon oxynitride (SiₓO_{y}N_{z}) or the like may be interposed between the polycrystalline Si forming the stress adjusting layer 5 and the encapsulating layer 32 for both warpage correction and affinity with the encapsulating layer 32. If long-term stability is needed, the polycrystalline Si may be coated with Si₃N₄ or the surface layer of polycrystalline Si may be partially converted to Si₃N₄.

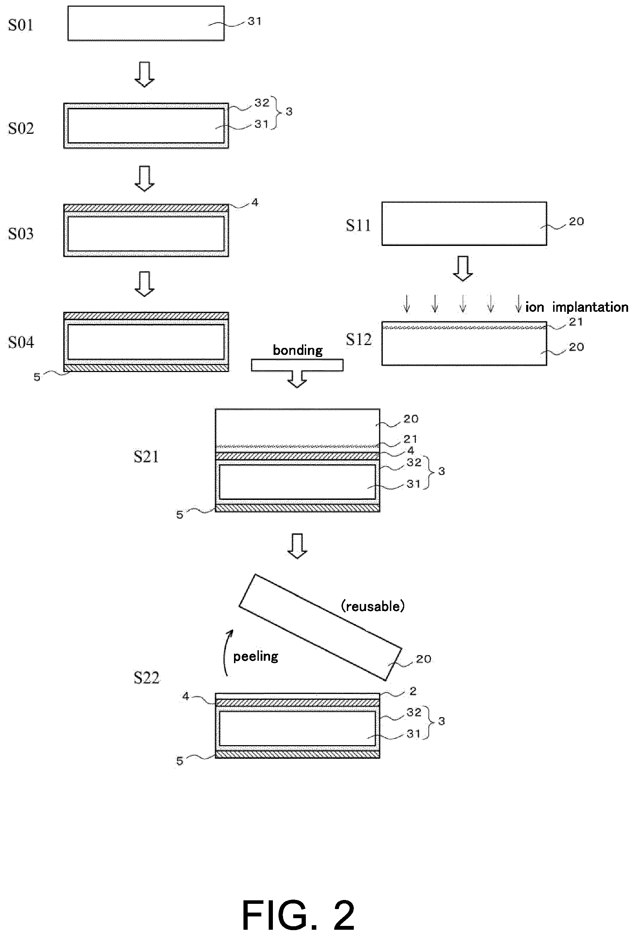

Then, with reference to FIG. 2, the procedure for the manufacturing method of the seed substrate for group III nitride epitaxial growth according to the embodiment of the present invention will be described. If a suitable method for forming each layer has already been described, a redundant explanation here is omitted.

First, core 31 consisting of nitride ceramic, is prepared (S01 in FIG. 2). Next, the encapsulating layer 32 with a thickness of between 0.05 µm and 1.5 um, inclusive, is deposited so as to wrap in the core 31 and the support substrate 3 is obtained (S02 in FIG. 2). In this case, the encapsulating layer 32 may be deposited by using an LPCVD. Next, the planarizing layer 4 with a thickness of between 0.5 µm and 3.0 µm, inclusive, is stacked on the upper surface of the support substrate 3 (S03 in FIG. 2). If necessary, the stress adjusting layer 5 is deposited on the bottom surface of the support substrate 3 (S04 in FIG. 2). The planarizing layer 4 and the stress adjusting layer 5 may be deposited at the same time.

Apart from S01-S04, a seed crystal, e.g., a Si<111> single crystal substrate 20, is prepared for peeling transfer of the seed crystal layer 2 (S11 in FIG. 2). Next, ion implantation is performed from one surface (ion implantation surface) of the single crystal substrate 20, and a peeling position (embrittlement layer) 21 is formed in the single crystal substrate 20 (S12 in FIG. 2).

Next, the ion implantation surface of the single crystal substrate 20 is bonded to the planarizing layer 4 formed on the support substrate 3 to obtain a bonded substrate (S21 in FIG. 2). Then, the single crystal substrate 20 is separated at the peeling position 21 of the single crystal substrate 20 in the bonded substrate (S22 in FIG. 2). In this way, a single crystal film of Si<111> is thinly transferred as a seed crystal layer 2 onto the planarizing layer 4 on the support substrate 3. On the other hand, the remaining section of the separated Si<111> single crystal substrate 20 can be repeatedly utilized by polishing the surface again and ion implanting its surface again.

A single crystal substrate other than Si<111> single crystal substrate may be prepared as the seed crystal in step S22. In this case, for example, aluminium nitride, aluminium gallium nitride, or gallium nitride epitaxially grown on a sapphire substrate by MOCVD or HVPE may be fabricated as the single crystal substrate. Alternatively, the single crystal substrate may be obtained by bonding small-diameter single crystals made by epitaxial growth of aluminium nitride or aluminium gallium nitride by MOCVD or HVPE using a small-diameter aluminium nitride single crystal fabricated by the sublimation method or an aluminium nitride substrate fabricated by the sublimation method as a base. Alternatively, the single crystal substrate may be obtained by bonding small-diameter single crystals made by epitaxial growth of aluminium nitride or aluminium gallium nitride by MOCVD or HVPE using a small-diameter gallium nitride single crystal obtained by growing gallium nitride crystal in liquid ammonia or Na flux as a base.

The above describes the structure and manufacturing procedure of the seed substrate 1 for epitaxial growth. As mentioned above, there are three main components of the present invention. The first of these is to minimize thermal stress by optimizing the thermal expansion coefficient difference between each multilayer film that encapsulates the core, or between the encapsulating layer, planarizing layer, and seed crystal layer, especially between the planarizing layer and the seed crystal layer, while considering the balance of their composition and film thickness. The second is to add a stress adjusting layer (including one that also serves for electrostatic chucking), if necessary, to the bottom surface of the support substrate and to achieve a configuration that balances and minimizes the thermal stresses. The third is to make the seed crystal film extremely thin, more than 0.04 um and less than 0.10 um, in order to completely remove the damaged portions of the seed crystal, improve the followability between the seed crystal layer and the planarizing layer, and reduce stress. The present invention makes it possible to economically obtain epitaxial substrates and solid substrates with very little warpage, voids, crystal defects, etc., high breakdown voltage, and very little high-frequency loss in devices.

The substrate according to the present invention significantly improves the characteristics of devices, such as light-emitting diodes used in the deep ultraviolet region (UVC; 200-280 nm), high-frequency devices or high-voltage devices for 5G communications and EV vehicles, while also significantly improving device manufacturing yields.

### EXAMPLES

The present invention will be described more specifically hereinafter by citing examples and comparative examples below, but the present invention is not limited to these examples.

### [Example 1]

### (Preparation of Support Substrate)

A commercially available AlN ceramic substrate was used for the polycrystalline ceramic core 31. The AlN ceramic substrate was made by mixing 10wt% AlN powder and 5wt% Y₂O₃ as a sintering agent with organic binders and solvents to make a green sheet, which was then degreased and sintered at 1900°C under an N₂ atmosphere. Both sides polished to ϕ8 inches x t725pm piece was used. The encapsulating layer 32 was formed by covering the entire AlN ceramic core 31 with a 0.1-pm-thick silicon oxynitride layer by LPCVD, and then encapsulating the entire core with a 0.4-um-thick Si₃N₄ layer using another LPCVD apparatus. The total thickness of the encapsulating layer 32 was 0.5 µm. For the purpose of planarization, as the planarizing layer 4, a 6 µm thick SiO₂ was further stacked on the Si₃N₄ layer only on one side of the top surface by using the plasma CVD (ICP-CVD apparatus). Then, after vitrification at 1000°C, the SiO₂ was planarized to a thickness of 2 µm (Ra = 0.2 nm) by CMP polishing and left at room temperature for a while, the substrate warped to 112 um in WARP. Since it is difficult to transfer a thin film of Si <111> single crystal substrate in this state, about 1 µm of SiOz as a stress adjustment layer 5 was deposited on the bottom layer of this support substrate 3 using the plasma CVD apparatus described above, and 0.3 µm of p-Si was further stacked for electrostatic chucking using the same apparatus. After that, vitrification at 1000°C was applied, and WARP was measured. The result was 5 um, a sufficiently small value, so it was used for thin-film transfer of Si seed crystals.

### (Preparation of Seed Crystal)

A commercially available Si<111> single crystal substrate of 35 inches in diameter and 725 µm in thickness, which had OSFs of 35 defects/cm² and an electrical resistivity (room temperature) of 1.5 kQ-cm, was prepared. Ion implantation of hydrogen was carried out on the Si<111> substrate at 95 keV, at a depth of 0.3µm, and with a dose of 6 × 10¹⁷ cm⁻².

### (Thin film transfer)

The ion implantation surface of this Si<111> substrate was bonded with the planarizing layer 4 of the supporting substrate 3 prepared earlier. After that, the seed crystal layer 2 of Si<111> was transferred to the supporting substrate 3 by peeling and separation at the peeling position (0.3 um depth where the ions were implanted). The ion-damaged portions of the transferred Si seed crystal layer 2 were completely removed, and the thickness of the Si seed crystal layer 2 was reduced to 0.085 um by CMP polishing and hydrofluoric acid etching to enable it to follow the thermal stress of the SiO₂ film that forms the planarizing layer 4.

The remaining Si<111> single crystal substrate after thin-film transfer could be used repeatedly as seed crystals for thin-film transfer of the seed crystal layer 2 by repeated ion implantation, which was extremely economical.

With this Example 1, a seed substrate 1 with a 2 µm-thick planarizing layer 4 and a 0.085 pm-thick Si<111> single crystal seed crystal layer 2 on a support substrate 3 with an AlN ceramic core 31 and encapsulating layer 32 was obtained. To investigate the characteristics of this seed substrate 1 as a seed substrate for epitaxial growth of GaN, the following brief evaluation was performed.

The above seed substrate 1 was placed in the reactor of the MOCVD apparatus, and epitaxial growth was performed. In this process, the epitaxial layers were deposited in the order of AlN and AlGaN from the seed substrate 1 side toward the growth direction, followed by the epitaxial growth of GaN. The structure of the epitaxial layers is not limited to this, for example, AlGaN may not be deposited, or AlN may be deposited further after AlGaN deposition. In this evaluation, 100 nm of AlN layer and 150 nm of AlGaN layer were formed. The total thickness of the epitaxial layer was 8 um. During epitaxial growth, TMAl (trimethylaluminum) can be used as the Al source, TMGa (trimethylgallium) can be used as the Ga source, and NH3 can be used as the N source, but not limited to these. The carrier gas can be N₂ and H₂, or any of them. The process temperature should preferably be around 900-1200°C.

Then, to evaluate dislocation density, etch pits were generated by a molten alkali (KOH) etching method, and etch pit density (EPD) was measured. In addition, X-ray rocking curve (XRC) measurements were performed to evaluate the crystallinity.

As a result, the EPD showed an extremely low dislocation density of 0.1 × 10⁴ cm⁻². The XRC measurements on a (0002) plane of the substrate yielded a half-value width FWHM (hereafter simply referred to as "FWHM of 0002XRC") of 108 arcsec, resulting in a high-quality GaN single crystal. These results show that the seed substrate 1 in this example has excellent characteristics as a seed substrate for epitaxial growth. When this epitaxial substrate with an epitaxial layer on the seed substrate 1 was used for a 30 GHz/20 Gbps high-frequency device, the surface temperature of the device was 39°C, and there was no temperature increase due to high-frequency loss that would cause a significant problem.

### [Example 2]

A single crystal Si substrate with an OSF of 5 defects/cm² and electrical resistivity (at room temperature) of 1.45 kQ-cm, 8 inches in diameter, and 725 µm thick was used as the seed crystal for the thin film transfer. Other conditions were the same as in Example 1, and experiments and evaluations were conducted. The EPD was 0.1 × 10⁴ cm⁻², the FWHM was 110 arcsec, and a high-quality GaN single crystal was obtained. According to the evaluation results of Example 1 and Example 2, even when the OFS of the Si single-crystal substrate was not less than 10 (Example 1), equivalent products were obtained as when the OFS was less than 10 (Example 2). This result shows that there is a broader choice of Si single crystal substrates and that less expensive Si substrates are possible to use.

### [Comparative Example 1]

The experiment was conducted in the same manner as in Example 1, except that the thickness of the final Si seed crystal layer was set to 0.15 um. As a result, the EPD showed an extremely high dislocation density of 9.8 × 10⁶ cm⁻². The XRC measurements on a (0002) plane of the substrate yielded a half-value width FWHM of 1204 arcsec, and the crystal was inferior to Example 1 in both dislocation density and half-value width.

As described above, according to the present invention, it is possible to provide high-quality, inexpensive seed substrates for epitaxial growth of group III nitride and epitaxial substrates with extremely low crystal defects, warpage, and voids.

### REFERENCE SIGNS LIST

1 Seed substrate for epitaxial growth
2 Seed crystal layer
3 Support substrate
4 Planarizing layer
5 Stress adjusting layer
20 Single crystal substrate
21 Peeling position

## Claims

1. A substrate for group-III nitride epitaxial growth comprising:
a supporting substrate having a structure in which a core consisting of nitride ceramic is wrapped in an encapsulating layer having a thickness of between 0.05 µm and 1.5 µm, inclusive;
a planarizing layer provided on an upper surface of the supporting substrate, the planarizing layer having a thickness of between 0.5 µm and 3.0 µm, inclusive, and
a seed crystal layer consisting of a single crystal, the seed crystal layer being provided on an upper surface of the planarizing layer and having a thickness of more than 0.04 µm and less than 0.1 µm.

2. The substrate for group-III nitride epitaxial growth according to claim 1, wherein the substrate further comprises a stress adjusting layer on the bottom surface of the supporting substrate.

3. The substrate for group-III nitride epitaxial growth according to claim 1 or 2, wherein the core is aluminum nitride ceramic.

4. The substrate for group-III nitride epitaxial growth according to any one of claims 1 to 3, wherein the encapsulating layer contains, at least, silicon nitride.

5. The substrate for group-III nitride epitaxial growth according to any one of claims 1 to 4, wherein the planarizing layer contains any one of silicon oxide, silicon oxynitride, and aluminum arsenide.

6. The substrate for group-III nitride epitaxial growth according to any one of claims 1 to 5, wherein the seed crystal layer is Si<111>, SiC, sapphire, aluminum nitride, aluminum gallium nitride, or gallium nitride.

7. The substrate for group-III nitride epitaxial growth according to claim 2, wherein the stress adjusting layer includes, at least, silicon.

8. A method for manufacturing a substrate for group-III nitride epitaxial growth comprising steps of:
preparing a core consisting of nitride ceramic;
obtaining a supporting substrate by depositing an encapsulating layer so as to wrap the core, the encapsulating layer having a thickness of between 0.05 µm and 1.5 um, inclusive;
depositing a planarizing layer on an upper surface of the support substrate, the planarizing layer having a thickness of between 0.5 µm and 3.0 um, inclusive; and
providing a seed crystal layer consisting of a single crystal with a thickness of more than 0.04 µm and less than 0.10 um on the upper surface of the planarizing layer.

9. The method for manufacturing a substrate for group-III nitride epitaxial growth according to claim 8, wherein the method further comprises a step of depositing a stress adjusting layer on a bottom surface of the supporting substrate.

10. The method for manufacturing a substrate for group-III nitride epitaxial growth according to claim 8 or 9, wherein the encapsulating layer is deposited by using an LPCVD method.

11. The method for manufacturing a substrate for group-III nitride epitaxial growth according to any one of claims 8 to 10, wherein the planarizing layer is deposited by using any one of a plasma CVD method, an LPCVD method, and a low-pressure MOCVD method.

12. The method for manufacturing a substrate for group-III nitride epitaxial growth according to any one of claims 8 to 11, wherein the step of providing the seed crystal layer includes the steps of:
preparing a single crystal substrate of a group III nitride, one surface of the single crystal substrate being an ion implantation surface;
forming a peeling position in the single crystal substrate by performing ion implantation from the ion implantation surface;
obtaining a bonded substrate by bonding the ion implantation surface and the planarizing layer; and
separating the bonded substrate into the seed crystal layer and a remaining section of the single crystal substrate at the peeling position.

13. The method for manufacturing a substrate for group III nitride epitaxial growth according to claim 12, wherein, in the step of preparing the single crystal substrate, aluminium nitride, aluminium gallium nitride or gallium nitride epitaxially grown on a sapphire substrate by MOCVD or HVPE is fabricated as the single crystal substrate.

14. The method for manufacturing a substrate for group III nitride epitaxial growth according to claim 13, wherein, in the step of preparing the single crystal substrate, the single crystal substrate may be obtained by bonding small-diameter single crystals made by epitaxial growth of aluminium nitride or aluminium gallium nitride by MOCVD or HVPE using a small-diameter aluminium nitride single crystal fabricated by the sublimation method or an aluminium nitride substrate fabricated by the sublimation method as a base.

15. The method for manufacturing a group III nitride epitaxial growth according to claim 12, wherein, in the step of preparing the single crystal substrate, the single crystal substrate is obtained by bonding small-diameter single crystals made by epitaxial growth of aluminium nitride or aluminium gallium nitride by MOCVD or HVPE using a small-diameter gallium nitride single crystal obtained by growing gallium nitride crystal in liquid ammonia or Na flux as a base.

16. The method for manufacturing a group III nitride epitaxial growth according to any one of claims 13 to 15, wherein, in the step of forming the peeling position, the peeling position is formed within the epitaxial layer grown by epitaxial growth.

17. The method for manufacturing a substrate for group-III nitride epitaxial growth according to any one of claims 13 to 16, wherein the remaining section of the single crystal substrate is reused as the base substrate for epitaxial growth.

18. The method for manufacturing a substrate for group-III nitride epitaxial growth according to any one of claims 12 to 17, wherein the remaining section of the single crystal substrate is reused as a single crystal substrate in production of a further different group III nitride composite substrate.

19. The method for manufacturing a substrate for group-III nitride epitaxial growth according to any one of claims 8 to 18, wherein the core is aluminum nitride ceramic.

20. The method for manufacturing a substrate for group-III nitride epitaxial growth according to any one of claims 8 to 19, wherein the encapsulating layer contains silicon nitride.

21. The method for manufacturing a substrate for group-III nitride epitaxial growth according to any one of claims 8 to 20, wherein the planarizing layer contains any one of silicon oxide, silicon oxynitride, and aluminum arsenide.

22. The method for manufacturing a substrate for group-III nitride epitaxial growth according to any one of claims 8 to 21, wherein the seed crystal layer is Si<111>, SiC, sapphire, aluminum nitride, or aluminum gallium nitride.

23. The method for manufacturing a substrate for group-III nitride epitaxial growth according to claim 9, wherein the stress adjusting layer includes, at least, silicon.
